# EUROPEAN PATENT APPLICATION

(11) **EP 2 071 625 A1**
(43) Date of publication of application: **17.06.2009**
(21) Application number: 08021012.3
(22) Date of filing: 03.12.2008
(51) Int. Cl.: H01L 23/66, H01L 23/64, H01L 25/16

(54) **Chip carrier with ferro/ferrimagnetic layers**

(30) Priority: 13.12.2007 US 956048
(71) Applicant: Broadcom Corporation, Irvine CA 92617 (US)
(72) Inventor: Rofougaran, Ahmadreza, Newport Coast, CA 92657 (US); Rofougaran, Maryam, Rancho Palos Verdes, CA 90275 (US)
(74) Representative: Jehle, Volker Armin

(57) **Abstract**

Methods and systems for an integrated circuit package with ferri/ferromagnetic layers are disclosed and may include processing a received signal via a hybrid including an integrated circuit bonded to a multi-layer package, the latter including integrated layers of ferrimagnetic material and/or ferromagnetic material (205A,205B,205C,207,209 and 217), metal interconnect materials (215A,215B) and insulating materials. The received signal may be filtered, amplified, and/or impedance matched via the integrated layers of ferrimagnetic material and/or ferromagnetic material. The integrated circuit (201) may be hybridized to the multi-layer package (213) utilizing a flip-chip bonding technique. The hybridized multi-layer package and integrated circuit may be coupled to a printed circuit board utilizing a flip-chip bonding technique. The ferromagnetic material and/or ferrimagnetic material may be deposited on the multi-layer package. The magnetic material may be deposited on the multi-layer package using an ink printing technique and/or a spin-on technique. One or more surface mount devices (219A,219B) may be coupled to the multi-layer package.

## Description

### CROSS-REFERENCE TO RELATED APPLICATIONS/INCORPORATION BY REFERENCE

[Not Applicable] FEDERALLY SPONSORED RESEARCH OR DEVELOPMENT

[Not Applicable] [MICROFICHE/COPYRIGHT REFERENCE]

[Not Applicable]

### FIELD OF THE INVENTION

Certain embodiments of the invention relate to wireless communication. More specifically, certain embodiments of the invention relate to a method and system for an integrated circuit package with ferri/ferromagnetic layers.

### BACKGROUND OF THE INVENTION

Mobile communications have changed the way people communicate and mobile phones have been transformed from a luxury item to an essential part of every day life. The use of mobile phones is today dictated by social situations, rather than hampered by location or technology. While voice connections fulfill the basic need to communicate, and mobile voice connections continue to filter even further into the fabric of every day life, the mobile Internet is the next step in the mobile communication revolution. The mobile Internet is poised to become a common source of everyday information, and easy, versatile mobile access to this data will be taken for granted.

As the number of electronic devices enabled for wireline and/or mobile communications continues to increase, significant efforts exist with regard to making such devices more power efficient. For example, a large percentage of communications devices are mobile wireless devices and thus often operate on battery power. Additionally, transmit and/or receive circuitry within such mobile wireless devices often account for a significant portion of the power consumed within these devices. Moreover, in some conventional communication systems, transmitters and/or receivers are often power inefficient in comparison to other blocks of the portable communication devices. Accordingly, these transmitters and/or receivers have a significant impact on battery life for these mobile wireless devices.

Further limitations and disadvantages of conventional and traditional approaches will become apparent to one of skill in the art, through comparison of such systems with the present invention as set forth in the remainder of the present application with reference to the drawings.

### BRIEF SUMMARY OF THE INVENTION

A system and/or method for an integrated circuit package with ferri/ferromagnetic layers, substantially as shown in and/or described in connection with at least one of the figures, as set forth more completely in the claims.

According to an aspect, a method for enabling communication is provided, the method comprising:
processing a received signal via a hybrid comprising an integrated circuit bonded to a multi-layer package, wherein said multi-layer package comprises one or more integrated layers of ferrimagnetic material and/or ferromagnetic material, metal interconnect materials and insulating materials.

Advantageously, the method further comprises filtering said received signal via said integrated circuit and said one or more integrated layers of ferrimagnetic material and/or ferromagnetic material.

Advantageously, the method further comprises amplifying said received signal via said integrated circuit and said one or more integrated layers of ferrimagnetic material and/or ferromagnetic material.

Advantageously, the method further comprises impedance matching said received signal via said integrated circuit and said one or more integrated layers of ferrimagnetic material and/or ferromagnetic material.

Advantageously, said multi-layer package and integrated circuit is mechanically coupled to a printed circuit board.

Advantageously, said multi-layer package and said integrated circuit are electrically coupled to a printed circuit board.

Advantageously, said ferromagnetic and/or ferrimagnetic material is deposited on said multi-layer package.

Advantageously, said ferromagnetic and/or ferrimagnetic material is deposited on said multi-layer package via an ink printing technique.

Advantageously, said ferromagnetic and/or ferrimagnetic material is deposited on said multi-layer package via a spin-on technique.

Advantageously, one or more surface mount devices are coupled to said multi-layer package.

According to an aspect, a system for wireless communication comprises:
an integrated circuit bonded to a multi-layer package, said integrated circuit and/or said multi-layer package processing a received signal, wherein said multi-layer package comprises one or more of integrated layers of ferrimagnetic material and/or ferromagnetic material, metal interconnect materials and insulating materials.

Advantageously, said integrated circuit and/or said multi-layer package filter said received signal via said one or more integrated layers of ferrimagnetic material and/or ferromagnetic material.

Advantageously, said integrated circuit and/or said multi-layer package amplify said received signal via said one or more integrated layers of ferrimagnetic material and/or ferromagnetic material.

Advantageously, said integrated circuit and/or said multi-layer package impedance match said received signal via said one or more integrated layers of ferrimagnetic material and/or ferromagnetic material.

Advantageously, said bonded multi-layer package and integrated circuit are mechanically coupled to a printed circuit board.

Advantageously, said bonded multi-layer package and integrated circuit are electrically coupled to a printed circuit board.

Advantageously, said ferromagnetic and/or ferrimagnetic material is deposited on said multi-layer package.

Advantageously, said ferromagnetic and/or ferrimagnetic material is deposited on said multi-layer package via an ink printing technique.

Advantageously, said ferromagnetic and/or ferrimagnetic material is deposited on said multi-layer package via a spin-on technique.

Advantageously, one or more surface mount devices is coupled to said multi-layer package.

According to an aspect, a system for wireless communication comprises:
an integrated circuit bonded to a multi-layer package, wherein said multi-layer package comprises one or more of integrated layers of ferrimagnetic material and/or ferromagnetic material, metal interconnect materials and insulating materials.

Advantageously, said integrated circuit bonded to a multi-layer package filters said received signal via said one or more integrated layers of ferrimagnetic material and/or ferromagnetic material.

Advantageously, said integrated circuit bonded to a multi-layer package amplifies said received signal via said one or more integrated layers of ferrimagnetic material and/or ferromagnetic material.

Various advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1 is a block diagram of an exemplary wireless system, which may be utilized in connection with an embodiment of the invention.

FIG. 2 is a block diagram illustrating a cross sectional view of a multi-layer package with magnetic layers, in accordance with an embodiment of the invention.

FIG 3. is a block diagram illustrating initial exemplary steps in the fabrication of a multi-layer package, in accordance with an embodiment of the invention.

FIG. 4 is a block diagram illustrating magnetic layer planarizing steps, in accordance with an embodiment of the invention.

FIG. 5 is a block diagram of a metallization and patterning step, in accordance with an embodiment of the invention.

FIG. 6 is a block diagram illustrating metal layer planarizing steps, in accordance with an embodiment of the invention.

FIG. 7 is a block diagram illustrating an exemplary second magnetic layer deposition step, in accordance with an embodiment of the invention.

FIG. 8 is a flow diagram illustrating exemplary steps in the fabrication of a multi-layer substrate.

### DETAILED DESCRIPTION OF THE INVENTION

Certain aspects of the invention may be found in a method and system for an integrated circuit package with ferri/ferromagnetic layers. Exemplary aspects of the invention may comprise processing a received signal via a hybrid comprising an integrated circuit coupled to a multi-layer package comprising one or more integrated layers of ferrimagnetic material and/or ferromagnetic material, metal interconnect materials and insulating materials. The received signal may be filtered, amplified, and/or impedance matched via the integrated layers of ferrimagnetic material and/or ferromagnetic material. The integrated circuit may be hybridized to the multi-layer package utilizing a flip-chip bonding technique. The hybridized multi-layer package and integrated circuit may be coupled to a printed circuit board utilizing a flip-chip bonding technique. The magnetic material may comprise a ferromagnetic material and/or a ferrimagnetic material, and may be deposited on top of and/or on bottom of the multi-layer package. The magnetic material may be deposited on the multi-layer package using an ink printing technique and/or a spin-on technique. One or more surface mount devices may be coupled to the multi-layer package.

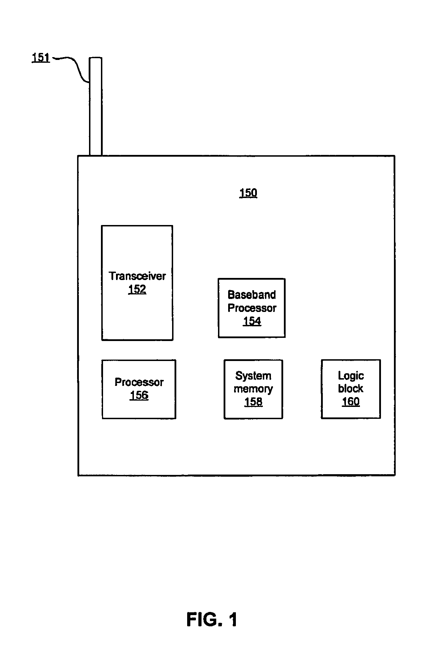

FIG. 1 is a block diagram of an exemplary wireless system, which may be utilized in accordance with an embodiment of the invention. Referring to FIG. 1, the wireless system 150 may comprise an antenna 151, a transceiver 152, a baseband processor 154, a processor 156, a system memory 158, and a logic block 160. The antenna 151 may be used for reception and/or transmission of RF signals.

The transceiver 152 may comprise suitable logic, circuitry, and/or code that may be enabled to modulate and upconvert baseband signals to RF signals for transmission by one or more antennas, which may be represented generically by the antenna 151. The transceiver 152 may also be enabled to downconvert and demodulate received RF signals to baseband signals. The RF signals may be received by one or more antennas, which may be represented generically by the antenna 151. Different wireless systems may use different antennas for transmission and reception. The transceiver 152 may be enabled to execute other functions, for example, filtering the baseband and/or RF signals, and/or amplifying the baseband and/or RF signals.

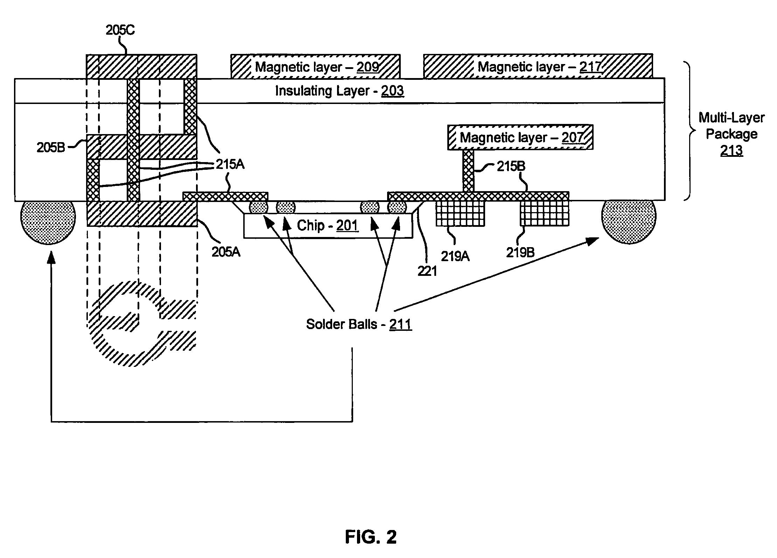

In an embodiment of the invention, the transceiver 152 may be integrated on a multi-layer package comprising magnetic layers deposited on the top, bottom and/or embedded within the multi-layer package. The magnetic layers may comprise ferromagnetic and/or ferromagnetic layers. In this manner, high inductance values may be obtained for devices such as transformers, inductors, and baluns. By utilizing ferromagnetic materials resulting in higher inductances than conventional discrete devices, the size of these devices may be greatly reduced, which may be increasingly important as the frequency of operation of the wireless system 150 may be extended to the 60 GHz range. The magnetic materials and multi-layer package are described further with respect to FIG. 2.

The ferrimagnetic material may be anisotropic, such that a magnetic field may align the magnetic dipoles in the material to produce a net (nonzero) dipole moment, which may cause the dipoles to precess at a frequency controlled by the strength of the magnetic field. A signal circularly polarized in the same direction at the precession may interact strongly with the dipole moments, while a signal circularly polarized in the opposite direction of the precession may interact weakly. Thus, signals may propagate through the ferrimagnetic material differently, depending on the direction of travel, which may be exploited to fabricate directional devices such as isolators, circulators, and gyrators. In addition, by controlling the magnetic field, the interaction with signals traveling through the ferrite may be altered, and this may be exploited to fabricate exemplary devices such as phase shifters, switches, and tunable resonators and/or filters.

The baseband processor 154 may comprise suitable logic, circuitry, and/or code that may be enabled to process baseband signals for transmission via the transceiver 152 and/or the baseband signals received from the transceiver 152. The processor 156 may be any suitable processor or controller such as a CPU or DSP, or any type of integrated circuit processor. The processor 156 may comprise suitable logic, circuitry, and/or code that may be enabled to control the operations of the transceiver 152 and/or the baseband processor 154. For example, the processor 156 may be utilized to update and/or modify programmable parameters and/or values in a plurality of components, devices, and/or processing elements in the transceiver 152 and/or the baseband processor 154. At least a portion of the programmable parameters may be stored in the system memory 158.

Control and/or data information, which may comprise the programmable parameters, may be transferred from other portions of the wireless system 150, not shown in FIG. 1, to the processor 156. Similarly, the processor 156 may be enabled to transfer control and/or data information, which may include the programmable parameters, to other portions of the wireless system 150, not shown in FIG. 1, which may be part of the wireless system 150.

The processor 156 may utilize the received control and/or data information, which may comprise the programmable parameters, to determine an operating mode of the transceiver 152. For example, the processor 156 may be utilized to select a specific frequency for a local oscillator, a specific gain for a variable gain amplifier, configure the local oscillator and/or configure the variable gain amplifier for operation in accordance with various embodiments of the invention. Moreover, the specific frequency selected and/or parameters needed to calculate the specific frequency, and/or the specific gain value and/or the parameters, which may be utilized to calculate the specific gain, may be stored in the system memory 158 via the processor 156, for example. The information stored in system memory 158 may be transferred to the transceiver 152 from the system memory 158 via the processor 156.

The system memory 158 may comprise suitable logic, circuitry, and/or code that may be enabled to store a plurality of control and/or data information, including parameters needed to calculate frequencies and/or gain, and/or the frequency value and/or gain value. The system memory 158 may store at least a portion of the programmable parameters that may be manipulated by the processor 156.

The logic block 160 may comprise suitable logic, circuitry, and/or code that may enable controlling of various functionalities of the wireless system 150. For example, the logic block 160 may comprise one or more state machines that may generate signals to control the transceiver 152 and/or the baseband processor 154. The logic block 160 may also comprise registers that may hold data for controlling, for example, the transceiver 152 and/or the baseband processor 154. The logic block 160 may also generate and/or store status information that may be read by, for example, the processor 156. Amplifier gains and/or filtering characteristics, for example, may be controlled by the logic block 160.

FIG. 2 is a block diagram illustrating a cross sectional view of a multi-layer package with magnetic layers, in accordance with an embodiment of the invention. Referring to FIG. 2, there is shown a chip 201, and insulating layer 203, magnetic layers 205A, 205B, 205C, 207, 209 and 217, solder balls 211, multi-layer package 213, metal interconnects 215A and 215B, surface mount components 219A and 219B, and thermal epoxy 221.

The chip 201, or integrated circuit, may comprise the transceiver 152 described with respect to FIG. 1, or may also comprise any other integrated circuit within the wireless system 150 that may require inductive components and/or devices. The chip 201 may be bump-bonded or flip-chip bonded to the multi-layer package 213 utilizing the solder balls 211. In this manner, wire bonds coupling the chip 201 to the multi-layer package 213 may be eliminated, reducing and/or eliminating uncontrollable stray inductances due to wire bonds. In addition, the thermal conductance out of the chip 201 may be greatly improved utilizing the solder balls 211 and the thermal epoxy 221. The thermal epoxy 221 may be electrically insulating but thermally conductive to allow for thermal energy to be conducted out of the chip 201 to the much larger thermal mass of the multilayer package 213.

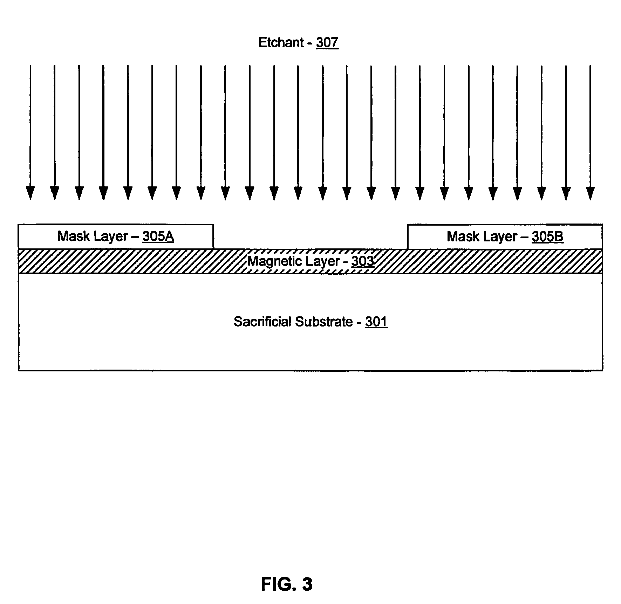

The magnetic layers 205A, 205B, 205C, 207, 209 and 217 may comprise ferromagnetic and/or ferrimagnetic layers utilized to define devices such as transformers, inductors, baluns, isolators, circulators, and gyrators. The magnetic materials may be deposited on the top, bottom and/or embedded within the multi-layer package 213. This process is described further with respect to FIGS. 3-8. The magnetic layers 205A, 205B and 205C may comprise an integrated transformer or balun, for example.

The solder balls 211 may comprise spherical balls of metal to provide electrical, thermal and physical contact between the chip 201 and the multi-layer package 213. In making the contact with the solder balls 211, the chip may be pressed with enough force to squash the metal spheres somewhat, and may be performed at an elevated temperature to provide suitable electrical resistance and physical bond strength. The solder balls 211 may also be utilized to provide electrical, thermal and physical contact between the multi-layer package 213 and a printed circuit board comprising other parts of the wireless system 150, described with respect to FIG. 1.

The metal interconnects 215A and 215B may comprise metal traces embedded in and/or deposited on the multilayer package 213 that may be utilized to electrically conductive paths between the chip 201 and devices in and/or on the multi-layer package 213, such as the integrated balun or transformer comprising the magnetic layers 205A, 205B and 205C, or the surface-mount devices 219A and 219B.

The metal interconnects 215A and 215B may comprise multiple metal traces for multiple conductive paths, and may provide electrical contact to the chip 201 via the solder balls 211. In addition, the metal interconnects 215A and 215B may not be limited to the number of interconnects shown in FIG. 2. Accordingly, there may be any number of interconnects embedded within the multi-layer package 213, depending on the number of contacts on the chip 201 coupled to the solder balls 211, and the number of magnetic layer and surface mount devices coupled to the multi-layer package 213.

The surface mount devices 219A and 219B may comprise discrete circuit elements such as resistors, capacitors, inductors, and diodes, for example. The surface mount devices 219A and 219B may be soldered to the multi-layer package 213 to provide electrical contact.

In operation, the chip 201 may comprise an RF front end, such as the RF transceiver 152, described with respect to FIG. 1, and may be utilized to transmit and receive RF signals. The chip 201 may be electrically coupled to inductive devices fabricated on and/or within the multi-layer package 213, such as transformers, baluns, and surface mount devices, for example. Heat from the chip 201 may be conducted to the multi-layer package via the thermal epoxy 221 and the solder balls 211.

FIG 3. is a block diagram illustrating initial exemplary steps in the fabrication of a multi-layer package, in accordance with an embodiment of the invention. Referring to FIG. 3, there is shown a sacrificial substrate 301, a magnetic layer 303, mask layers 305A and 305B, and an etchant 307.

The sacrificial substrate 301 may comprise a mechanical substrate to support the deposited structures utilized to form integrated devices. In an embodiment of the invention, the sacrificial substrate 301 may be thinned or removed after the required metal and magnetic layers may be deposited and fabricated.

The magnetic layer 303 may comprise a ferromagnetic or ferrimagnetic layer that may be deposited on the sacrificial substrate 301. The magnetic layer 303 may be deposited by a plurality of techniques, such as evaporation, chemical vapor deposition, sputtering, spin-on with a liquid solution, or ink printing technique, for example. The ink printing technique may comprise dissolving ferrimagnetic or ferromagnetic material in an ink solution to be sprayed or printed on the surface of the sacrificial substrate 301. In instances where a pattern is directly printed onto a surface, the mask layer deposition and etching described here may be skipped.

The mask layer 305A may comprise a layer of material such as photoresist or an insulator such as silicon dioxide, for example, that may be deposited and patterned to delineate a structure to be transferred to the magnetic layer 303.

The etchant 307 may comprise a wet chemical etchant solution, or may comprise a dry etchant, such as is used in reactive ion etching, for example. The etchant 307 may remove exposed portions of the magnetic material 303 not protected by the mask layers 305A and 305B.

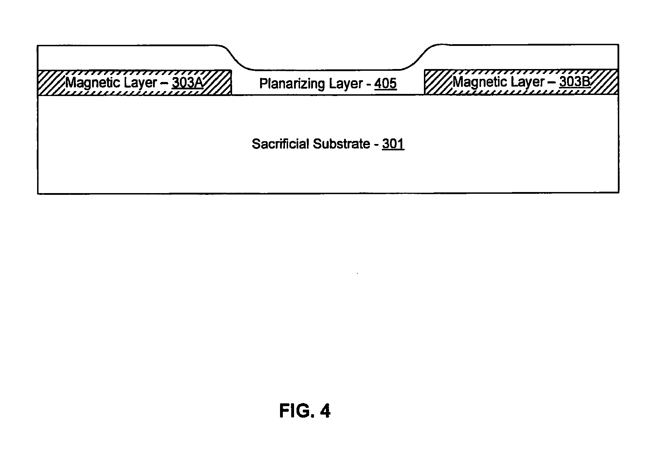

FIG. 4 is a block diagram illustrating magnetic layer planarizing steps, in accordance with an embodiment of the invention. Referring to FIG. 4, there is shown the sacrificial substrate 301, the remaining magnetic layers 403A and 403B, and a planarizing layer 405. The planarizing layer may comprise an insulating material to isolate electrically conductive material and may provide mechanical support to the structure. The planarizing layer 405 may be deposited via a spin-on, ion-beam sputtering, or thermal or electron-beam evaporation process, for example. Following deposition of the planarizing layer 405, the structure may be planarized by mechanical and/or chemical-mechanical polishing to remove the planarizing layer 405 material on top of the magnetic layers 403A and 403B.

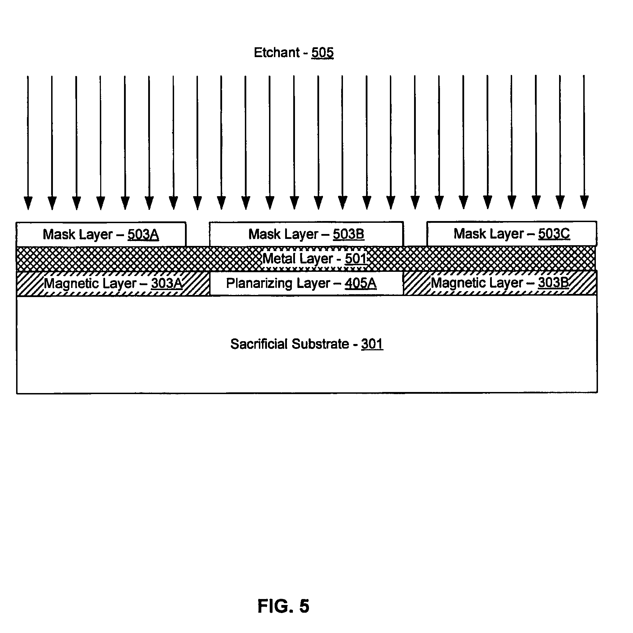

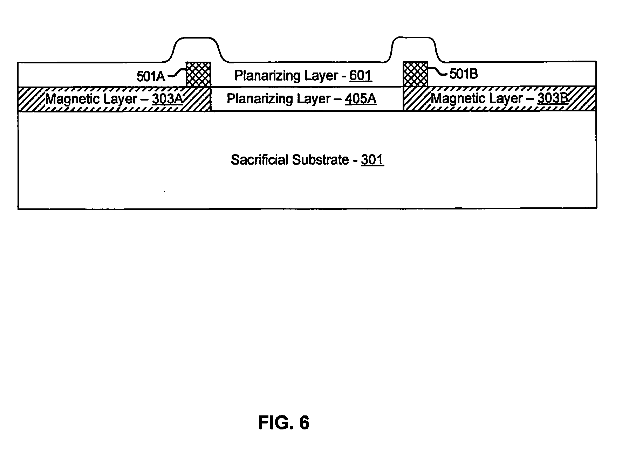

FIG. 5 is a block diagram of a metallization and patterning step, in accordance with an embodiment of the invention. Referring to FIG. 5, there is shown the sacrificial substrate 301, the remaining magnetic layers 303A and 303B, a remaining planarizing layer 405A, a deposited metal layer 501, patterned mask layers 503A, 503B, and 503C, and an etchant 505. The remaining planarizing layer may be formed by the polishing step described with respect to FIG. 4. The deposited metal layer 501 may be deposited by thermal evaporation, electron-beam evaporation, sputtering, or ion beam deposition, for example. The mask layers 503A, 503B and 503C may be substantially similar to the mask layers 305A and 305B described with respect to FIG. 3. The etchant 505 may be similar to the etchant 307, described with respect to FIG. 3, but may comprise a different material due to the different material to be etched, specifically the metal layer 501. The etchant 505 may remove the portions of the metal layer 501 not protected by the mask layers 503A, 503B and 503C. Following the etching process, the mask layers 503A, 503B and 503C may be removed and a planarizing layer may be deposited on top of the remaining metal and the layers beneath as shown in FIG. 6.

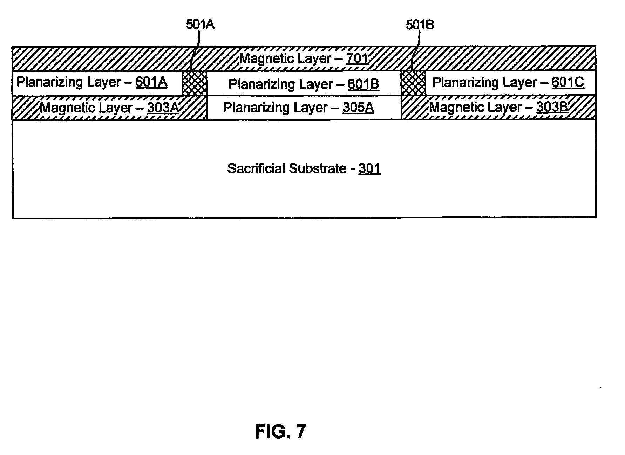

FIG. 6 is a block diagram illustrating metal layer planarizing steps, in accordance with an embodiment of the invention. Referring to FIG. 6, there is shown the sacrificial substrate 301, the remaining magnetic layers 303A and 303B, the remaining planarizing layer 405A, the remaining metal layers 501A and 501 B, and the planarizing layer 601. The planarizing layer 601 may be substantially similar to the planarizing layer 405, described with respect to FIG. 4. Following deposition of the planarizing layer 601, the structure may be planarized by mechanical and/or chemical-mechanical polishing to remove the planarizing layer 601 material on top of the remaining metal layers 501A and 501 B. Another magnetic layer may be deposited on the planarized structure, as shown in FIG. 7.

FIG. 7 is a block diagram illustrating an exemplary second magnetic layer deposition step, in accordance with an embodiment of the invention. Referring to FIG. 7, there is shown the sacrificial substrate 301, the remaining magnetic layers 303A and 303B, the remaining planarizing layer 405A, the remaining metal layers 501 A and 501 B, remaining planarizing layers 601A, 601 B and 601C, and a deposited magnetic layer 701. The sacrificial substrate 301, the remaining magnetic layers 303A and 303B, the remaining planarizing layer 405A, the remaining metal layers 501A and 501 B may be as described with respect to FIG. 5, and the remaining planarizing layers 601A, 601B and 601C may be formed by the deposition and planarization polishing described with respect to FIG. 5.

The magnetic layer 710 may be deposited similarly to the magnetic layer 303 described with respect to FIG. 3. The fabrication process described up to this point may be repeated a plurality of times to fabricate conductive lines and magnetic structures as required for the multi-layer package 213 to be coupled to the chip 201, described with respect to FIG. 2. In addition, the sacrificial substrate may be thinned or removed to allow for contact to the embedded metal and magnetic layers. Furthermore, magnetic layers may be deposited on top and on bottom of the resulting structure, which may comprise the multi-layer package 213 described with respect to FIG. 2. An integrated circuit, such as the chip 201, may then be flip-chip bonded to the multi-layer package to create the structure described with respect to FIG. 2.

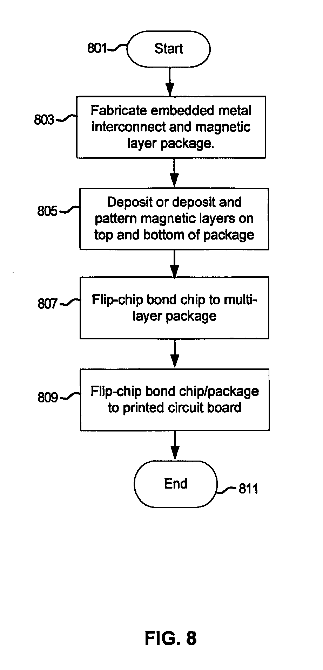

FIG. 8 is a flow diagram illustrating exemplary steps in the fabrication of a multi-layer substrate with embedded and deposited magnetic layers. Referring to FIG. 8, in step 803 after start step 801, the embedded metal interconnect and magnetic layer structure, or package, may be fabricated. In step 805, magnetic layers may be deposited on top and/or on bottom of the multi-layer package to fabricate magnetic devices. In step 807, the chip may be flip-chip bonded to the multi-layer package, followed by step 809, where the chip/package hybrid may be flip-chip bonded to a printed circuit board, which may comprise an RF transceiver, for example,

In an embodiment of the invention, a method and system are disclosed for processing a received signal via a hybrid comprising an integrated circuit 201 coupled to a multi-layer package 213 comprising one or more integrated layers of ferrimagnetic material and/or ferromagnetic material 205A, 205B, 205C, 209, 217, 307 and 701, metal interconnect materials 215A, 215B, and 501, and insulating materials 203, 405A, 601A, 601B and 601C. The received signal may be filtered, amplified, and/or impedance matched via the integrated layers of ferrimagnetic material and/or ferromagnetic material. The integrated circuit 201 may be hybridized to the multi-layer package 213 utilizing a flip-chip bonding technique. The hybridized multi-layer package 213 and integrated circuit 201 may be coupled to a printed circuit board utilizing a flip-chip bonding technique. The magnetic material 205A, 205B, 205C, 209, 217, 207, 307 and 701 may comprise a ferromagnetic material and/or a ferrimagnetic material, and may be deposited on top of and/or on bottom of the multi-layer package 213. The magnetic material 205A, 205B, 205C, 209, 217, 207, 307 and 701 may be deposited on the multi-layer package using an ink printing technique and/or a spin-on technique. One or more surface mount devices 219A and 219B may be coupled to the multi-layer package.

Certain embodiments of the invention may comprise a machine-readable storage having stored thereon, a computer program having at least one code section for wireless communication, the at least one code section being executable by a machine for causing the machine to perform one or more of the steps described herein.

Accordingly, aspects of the invention may be realized in hardware, software, firmware or a combination thereof. The invention may be realized in a centralized fashion in at least one computer system or in a distributed fashion where different elements are spread across several interconnected computer systems. Any kind of computer system or other apparatus adapted for carrying out the methods described herein is suited. A typical combination of hardware, software and firmware may be a general-purpose computer system with a computer program that, when being loaded and executed, controls the computer system such that it carries out the methods described herein.

One embodiment of the present invention may be implemented as a board level product, as a single chip, application specific integrated circuit (ASIC), or with varying levels integrated on a single chip with other portions of the system as separate components. The degree of integration of the system will primarily be determined by speed and cost considerations. Because of the sophisticated nature of modern processors, it is possible to utilize a commercially available processor, which may be implemented external to an ASIC implementation of the present system. Alternatively, if the processor is available as an ASIC core or logic block, then the commercially available processor may be implemented as part of an ASIC device with various functions implemented as firmware.

The present invention may also be embedded in a computer program product, which comprises all the features enabling the implementation of the methods described herein, and which when loaded in a computer system is able to carry out these methods. Computer program in the present context may mean, for example, any expression, in any language, code or notation, of a set of instructions intended to cause a system having an information processing capability to perform a particular function either directly or after either or both of the following: a) conversion to another language, code or notation; b) reproduction in a different material form. However, other meanings of computer program within the understanding of those skilled in the art are also contemplated by the present invention.

While the invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiments disclosed, but that the present invention will include all embodiments falling within the scope of the appended claims.

## Claims

1. A method for enabling communication, the method comprising:
processing a received signal via a hybrid comprising an integrated circuit bonded to a multi-layer package, wherein said multi-layer package comprises one or more integrated layers of ferrimagnetic material and/or ferromagnetic material, metal interconnect materials and insulating materials.

2. The method according to claim 1, comprising filtering said received signal via said integrated circuit and said one or more integrated layers of ferrimagnetic material and/or ferromagnetic material.

3. The method according to claim 1, comprising amplifying said received signal via said integrated circuit and said one or more integrated layers of ferrimagnetic material and/or ferromagnetic material.

4. The method according to claim 1, comprising impedance matching said received signal via said integrated circuit and said one or more integrated layers of ferrimagnetic material and/or ferromagnetic material.

5. The method according to claim 1, wherein said multi-layer package and integrated circuit is mechanically coupled to a printed circuit board.

6. A system for wireless communication, the system comprising:
an integrated circuit bonded to a multi-layer package, said integrated circuit and/or said multi-layer package processing a received signal, wherein said multi-layer package comprises one or more of integrated layers of ferrimagnetic material and/or ferromagnetic material, metal interconnect materials and insulating materials.

7. The system according to claim 6, wherein said integrated circuit and/or said multi-layer package filter said received signal via said one or more integrated layers of ferrimagnetic material and/or ferromagnetic material.

8. The system according to claim 6, wherein said integrated circuit and/or said multi-layer package amplify said received signal via said one or more integrated layers of ferrimagnetic material and/or ferromagnetic material.

9. The system according to claim 6, wherein said integrated circuit and/or said multi-layer package impedance match said received signal via said one or more integrated layers of ferrimagnetic material and/or ferromagnetic material.

10. A system for wireless communication, the system comprising:
an integrated circuit bonded to a multi-layer package, wherein said multi-layer package comprises one or more of integrated layers of ferrimagnetic material and/or ferromagnetic material, metal interconnect materials and insulating materials.
